# DEMANDE DE BREVET EUROPEEN

(11) **EP 2 947 699 A1**
(43) Date de publication de la demande: **25.11.2015**
(21) Numéro de dépôt: 14305748.7
(22) Date de dépôt: 20.05.2014
(51) Int. Cl.: H01L 31/0304, H01L 31/0687, H01L 31/0693, H01L 31/18

(54) **Cellule photovoltaïque multi-jonctions à base de matériaux antimoniures**

(71) Demandeur: Université de Montpellier, 34090 Montpellier (FR); Centre National de la Recherche Scientifique, 75016 Paris (FR)
(72) Inventeur: Cuminal, Yvan, 34160 Saint-Drezery (FR); Giudicelli, Emmanuel, 34090 Montpellier (FR); Martinez, Frédéric, 34160 SAINT-DREZERY (FR)
(74) Mandataire: Pontet Allano & Associes

(57) **Abrégé**

L'invention concerne une cellule photovoltaïque utilisable sous forte concentration solaire (≥1000soleils). La cellule selon l'invention consiste en une cellule comprenant au moins une jonction réalisée sur un substrat à base d'antimoniure de gallium, ladite au moins une jonction comprenant deux alliages à base d'un matériau antimoniure (Ga₁₋ₓAlₓAs_{y}Sb_{1-y}) en accord de maille sur le substrat GaSb. En cas de plusieurs jonctions, deux jonctions voisines sont séparées par une jonction tunnel.

## Description

La présente invention se rapporte à une cellule photovoltaïque. Elle trouve une application particulièrement intéressante dans des applications sous forte concentration solaire. Mais elle est d'un cadre plus large puisqu'elle peut également être utilisée sans concentration solaire.

Dans un contexte global de réduction des émissions de gaz à effet de serre qui implique un moindre recours aux énergies fossiles pour la production d'énergie, de nombreux pays se sont engagés à augmenter la part des énergies renouvelables. Compte tenu de la dégradation globale de l'économie, l'enjeu est double : il s'agit de développer des systèmes de production ou de conversion énergétique qui soient à la fois vertueux d'un point de vue environnemental et économiquement compétitif par rapport aux systèmes à base d'énergies fossiles. Cet objectif ne peut être atteint sans une diminution du coût de production de l'énergie d'origine renouvelable, qui nécessite dans certains cas une augmentation des rendements des systèmes de conversion actuels.

Il a été montré que pour réduire le coût de l'électricité d'origine solaire plusieurs solutions sont envisageables :
a. diminution des coûts de production des technologies existantes pour un rendement de conversion donné. Dans ce domaine, surtout avec les technologies Silicium de première génération, les marges de manoeuvre sont aujourd'hui assez faibles puisque l'arrivée massive de nouveaux acteurs industriels sur le marché du photovoltaïque ces dernières années a permis de diviser par 6 le prix des cellules Si en 3 ans, ainsi le prix d'installations de l'électricité photovoltaïque avec ce type de technologie est aujourd'hui de 1euro/Wc.
b. - augmenter les rendements de conversion des cellules : Ce levier ne peut plus être utilsé avec les technologies Silicium de première génération puisque ces cellules ont quasiment atteint leurs limites thermodynamiques et les marges de progression avec ce type de cellules sont aujourd'hui marginales ce qui n'est pas le cas avec des cellules multi-jonctions dites de 3^{ème} génération dont le potentiel théorique en terme de rendement est quasi infini, cet avantage est encore accentué par une utilisation sous concentration solaire. La filière photovoltaïque pour les très fortes concentrations concerne des systèmes dans lesquels le flux solaire a été concentré par des systèmes optiques permettant d'obtenir des irradiances solaires supérieures à 1000 fois l'irradiance avant concentration.
c. Utiliser des systèmes optiques permettant de concentrer le flux solaire : un système de conversion photovoltaïque sous concentration (CPV) peut être réalisé simplement en plaçant une cellule solaire au foyer d'un concentrateur optique. Le courant de court-circuit (Icc) de la cellule étant directement proportionnel au flux solaire absorbé, la surface de cellule nécessaire pour produire une quantité donnée d'électricité peut alors être réduite d'un facteur égal au facteur de concentration (X) du rayonnement solaire. De plus, la tension en circuit ouvert (Voc) croît théoriquement comme Ln(X) quand la cellule est exposée au rayonnement solaire concentré, ce qui procure un gain équivalent en termes de rendement de conversion. En pratique cependant, le gain relatif excède rarement 25% pour un facteur de concentration typique de quelques centaines de soleils car la résistance série de la cellule induit également des pertes joules qui augmentent comme le carré du courant, donc proportionnellement au carré de X. De plus, le gain de rendement, lié à l'augmentation de Voc, est en partie effacé par la perte de puissance solaire reçue liée au rendement optique du concentrateur qui diminue également pour les très fortes concentrations. En outre, l'économie réalisée sur les cellules ne doit pas être inférieure au surcoût des systèmes de concentration et de suivi du soleil. L'utilisation de concentrateurs est néanmoins aujourd'hui la seule option technologique permettant d'utiliser des cellules 3ème génération à base d'éléments III-V pour des applications terrestres.

Jusque dans les années 90, des cellules à base de silicium étaient utilisées dans les concentrateurs mais le potentiel de cette filière est très limité pour la concentration, en raison notamment des performances intrinsèques insuffisantes de ce type de cellules et de la chute importante de leur rendement avec l'élévation de leur température. C'est pourquoi les cellules de 1^{ère} génération ne sont pas utilisées pour une utilisation sous concentration au profit de la filière III-V, bien plus prometteuse, du moins dans le domaine des fortes concentrations solaires.

On connait une cellule triple jonction en GaInP/GaAs/GaInNAs de 0,3cm² de la société américaine Solar Junction® avec un rendement de 44% mesuré pour un taux de concentration 942X (irradiance directe de 942kW/m²).

On connait le document WO2012149022 décrivant une cellule à triple jonction GaInP2/GaAs/Ge dans un système sous forte concentration avec suivi solaire.

On connait une cellule triple jonction en GaInAs/GaAs/GaInP sur Silicium présentant un rendement de 44,4% mesuré pour un facteur de concentration de 302X. http://sharp-world.com/corporate/news/130614.html

La présente invention a pour objet une cellule photovoltaïque présentant un haut rendement de conversion à forte concentration.

Un autre objet de l'invention est une cellule apte à absorber un large spectre solaire.

L'invention a encore pour objet une réduction du coût de production de l'électricité d'origine photovoltaïque sous forte et très forte concentration par rapport à l'état de l'art antérieur.

On atteint au moins l'un des objectifs précités avec une cellule photovoltaïque utilisable sous forte concentration solaire avec un rendement optimum. La cellule selon l'invention consiste en une cellule comprenant au moins une jonction réalisée sur un substrat à base d'antimoniure de gallium (GaSb), ladite au moins une jonction étant réalisée à base d'alliage antimoniure en accord de maille sur le substrat.

Par forte concentration solaire on entend une irradiance solaire du soleil qui serait multipliée par un nombre supérieur ou égal à 1000, voir supérieur ou égal à 900. On connait dans l'état de l'art des dispositifs thermophotovoltaïques (TPV). Ces dispositifs ont pour principe la production d'électricité à partir du rayonnement dans l'infrarouge d'un corps noir sous l'effet de la chaleur. De tels dispositifs ont pour vocation de convertir l'élévation de température d'un absorbeur (corps noir) en électricité, que cette élévation de température soit d'origine solaire ou non. Les dispositifs TPV nécessitent l'utilisation d'un corps noir dont le rôle est de convertir l'élévation de température en rayonnement infrarouge ce qui n'est pas le cas de la présente invention où le principe est justement d'éviter tout échauffement. De plus les dispositifs TPV ont une architecture généralement simple et des technologies bas coût compte tenu des faibles rendements de conversions obtenus.

Avec la cellule selon l'invention, on exploite particulièrement le potentiel de la filière III-Sb. Le substrat est généralement du GaSb. La cellule est de préférence réalisée par croissance épitaxiale par jet moléculaire (MBE pour *Molecular Beam Epitaxy*) ou MOCVD (Metalorganic Vapour Phase Epitaxy) de façon à obtenir une cellule monolithique. L'utilisation de matériaux antimoniures (III-Sb) permet d'atteindre un très haut rendement lors d'une utilisation sous forte concentration solaire.

La réalisation de plusieurs jonctions sur le substrat permet de couvrir un spectre large du flux solaire. Idéalement, la cellule photovoltaïque est une cellule multi-jonctions (au moins deux jonctions) sans limitation du nombre de jonctions. Les différentes jonctions sont préférentiellement des empilements réalisés par croissance épitaxiale.

La cellule selon l'invention, du fait de la très bonne complémentarité des gaps des matériaux antimoniures constitue une solution très prometteuse et innovante pour une utilisation sous flux solaire fortement concentré. En effet la très grande variété des gaps accessibles, grâce à l'utilisation d'alliages tous en accord de maille sur le substrat GaSb, permet d'envisager une utilisation optimale du spectre solaire avec un nombre minimum de jonctions. Selon une caractéristique avantageuse de l'invention, en cas de plusieurs jonctions, deux jonctions voisines peuvent être séparées par une jonction tunnel, et les jonctions peuvent être constituées par des alliages de même nature et de compositions différentes tous en accord de maille sur le substrat GaSb.

Selon une caractéristique avantageuse de l'invention, ladite au moins une jonction peut présenter un gradient du niveau d'énergie de gap.

Avantageusement, l'alliage antimoniure est un matériau quaternaire. On peut envisager d'autres types de matériaux tels que ternaire ou quinaire.

Avantageusement, chaque alliage peut être un matériau antimoniure quaternaire Ga₁₋ₓAlₓAs_{y}Sb_{1-y}

Selon un mode de réalisation préféré de l'invention, la cellule peut comprendre efficacement trois jonctions :
- une première jonction à base de deux matériaux composés chacun d'antimoniure de gallium et dopés respectivement de type n et de type p,
- une seconde jonction à base de deux matériaux dopés respectivement de type n et de type p, chacun étant un alliage quaternaire comprenant de l'antimoine.
- une troisième jonction à base de deux matériaux dopés respectivement de type n et de type p, chacun étant alliage quaternaire comprenant de l'antimoine.

De préférence, l'alliage quaternaire est un matériau Ga₁₋ₓAlₓAs_{y}Sb_{1-y} avec de préférence x compris entre 0 et 1, y=(0,0396.x)/(0.0446+0.0315.x).

Ce matériau selon l'invention est avantageusement conçu par épitaxie (par jets moléculaires ou en phase vapeur aux organométalliques) en faisant varier x et en ajustant y, c'est-à-dire la composition d'arsenic de façon à conserver l'accord de maille pour tous matériaux quaternaires selon l'invention. X varie avec le niveau d'énergie de gap du matériau, et y varie avec le paramètre de maille du matériau.

Lors de la conception du matériau par croissance épitaxiale, on fait varier la composition des éléments constitutifs du matériau (en faisant notamment varier les paramètres x et y dans l'exemple d'un matériau quaternaire tel que décrit ci-dessus) de façon continue ou par paliers de façon à obtenir pour une jonction prédéterminée, non pas un niveau d'énergie de gap unique, mais une variation continue ou par paliers de l'énergie de gap. Par exemple, plus on se rapproche du substrat, plus l'énergie de gap diminue. Le gradient d'énergie de gap est avantageusement réalisé de cette manière.

La première jonction est avantageusement directement réalisée sur le substrat.

En complément notamment de ce qui précède, on peut envisager une disposition dans laquelle le niveau d'énergie de gap de la première jonction est égal à environ 0.726 eV ; le niveau d'énergie de gap de la seconde jonction est égal à environ 1.22 eV ; et le niveau d'énergie de gap de la troisième jonction est égal à environ 1.6 eV. On met à profit ainsi la complémentarité des niveaux d'énergie.

Plus précisément et à titre d'exemple non limitatif, l'alliage de la troisième jonction peut être le matériau Al_{0.9}Ga_{0.1}As_{0.085}Sb_{0.95}. De la même manière, l'alliage de la seconde jonction peut être le matériau Al_{0.4}Ga₀.₆As_{0.035}Sb_{0.965}. Ces alliages sont conçus de façon à maximiser le rendement sous forte concentration du soleil.

Selon une caractéristique avantageuse de l'invention, les jonctions tunnels sont réalisées en InAs/GaSb avec des dopages compris entre 1.10¹⁹ cm⁻³ et 10.10¹⁹ cm⁻³, de préférence à 1.10¹⁹ cm⁻³. Par exemple, l'épaisseur totale peut être de 30nm environ.

Par ailleurs, chaque jonction peut être dopée entre 1.10¹⁶ cm⁻³ et 10.10¹⁶ cm⁻³ pour les absorbeurs de type n, de préférence à 5.10¹⁶ cm⁻³, et entre 1.10¹⁸ cm⁻³ et 10.10¹⁸ cm⁻³ pour les émetteurs de type p, de préférence à 5.10¹⁸ cm⁻³.

A titre d'exemple non limitatif, la cellule selon l'invention peut présenter les caractéristiques dimensionnelles suivantes :
- le substrat présente une épaisseur de 350µm ;
- la première jonction (jonction du bas) réalisée en GaSb présente une épaisseur de 4µm pour le matériau de type n et 0.2µm pour le matériau de type p ;
- la seconde jonction (jonction du milieu) présente une épaisseur de 4µm pour le matériau de type n et de 0.4µm pour le matériau de type p ;
- la troisième jonction (jonction du haut) présente une épaisseur de 3µm pour le matériau de type n et de 0.55µm pour le matériau de type p.

Les jonctions tunnels peuvent présenter chacun une épaisseur de 15nm par matériau de type p ou n.

Avantageusement, chaque jonction tunnel est une diode dont le matériau de type n présente un dopage supérieur au dopage de l'alliage de type n directement voisine. Et chaque jonction tunnel est une diode dont le matériau de type p présente un dopage supérieur au dopage de l'alliage de type p directement voisine.

D'autres avantages et caractéristiques de l'invention apparaîtront à l'examen de la description détaillée d'un mode de mise en oeuvre nullement limitatif, et des dessins annexés, sur lesquels :
La figure 1 est une vue schématique très simplifiée d'un dispositif de conversion photovoltaïque sous forte concentration solaire ;
La figure 2 est une vue schématique d'une cellule quaternaire à grand gap selon l'invention ;
La figure 3 est une vue schématique d'une cellule quaternaire à gap intermédiaire selon l'invention ;
La figure 4 est une vue schématique d'une cellule quaternaire tandem (deux jonctions) selon l'invention ;
La figure 5 est une vue schématique d'une cellule quaternaire triple jonctions selon l'invention ;
La figure 6 est une vue schématique d'une cellule quaternaire optimisée triple jonctions selon l'invention ; et
La figure 7 est une vue schématique d'une jonction à gradient d'énergie de gap.

La cellule selon la présente invention ouvre une nouvelle voie technologique en ce qu'elle consiste en une cellule multi-jonctions à base de matériaux antimoniures (GaSb, GaAlAsSb, ...) fabriquées de façon monolithique par MBE (*Molecular Beam Epitaxy*). Une telle cellule, du fait de la très bonne complémentarité des gaps des matériaux (0,725eV pour GaSb, jusqu'à 1,64ev pour le gap du quaternaire GaAlAsSb (en gap indirect) et 2 eV (en gap indirect) ) en accord de maille sur GaSb, constitue une alternative crédible et originale aux cellules existantes pour une utilisation sous flux solaire fortement concentré.

Selon l'invention, les alliages utilisés permettent d'ajuster indépendamment le gap et le paramètre de maille des matériaux.

La mise en oeuvre d'un tel flux solaire fait intervenir des systèmes optiques à concentration. Deux grandes technologies de concentrateurs sont actuellement utilisées pour la conversion photovoltaïque sous concentration: les systèmes à réflexion, utilisant des concentrateurs paraboliques, et les systèmes à réfraction, à base de lentilles de Fresnel. Avec des concentrateurs paraboliques, on peut atteindre des taux de concentration très élevés (X> 10000), alors que les lentilles de Fresnel ne permettent guère de dépasser un facteur 1000 à 1500. Dans les deux cas, l'utilisation d'un système de suivi du soleil (« tracker ») est nécessaire. D'autres concepts tels que les concentrateurs luminescents permettraient de se dispenser de « tracker », mais leurs performances sont aujourd'hui encore médiocres.

La cellule selon la présente invention peut être intégrée dans des panneaux solaires associés à tout type de système photovoltaïque sous concentration. A titre d'exemple non limitatif, la cellule selon l'invention peut avantageusement être utilisée dans un système photovoltaïque tel que décrit dans le document WO2012/149022. Ce document WO2012/149022 décrit un système de suivi solaire pour dispositif photovoltaïque sous concentration. La cellule selon l'invention peut être utilisée en lieu et place de la cellule triple jonctions décrit dans ce document WO2012/149022, à savoir un alliage comprenant du phosphure d'indium-gallium, de l'arséniure de gallium et du germanium GaInP. La cellule de l'art antérieur permet une bande passante de conversion solaire s'étendant du spectre proche ultraviolet 350nm jusqu'au spectre proche infrarouge à environ 1600nm.

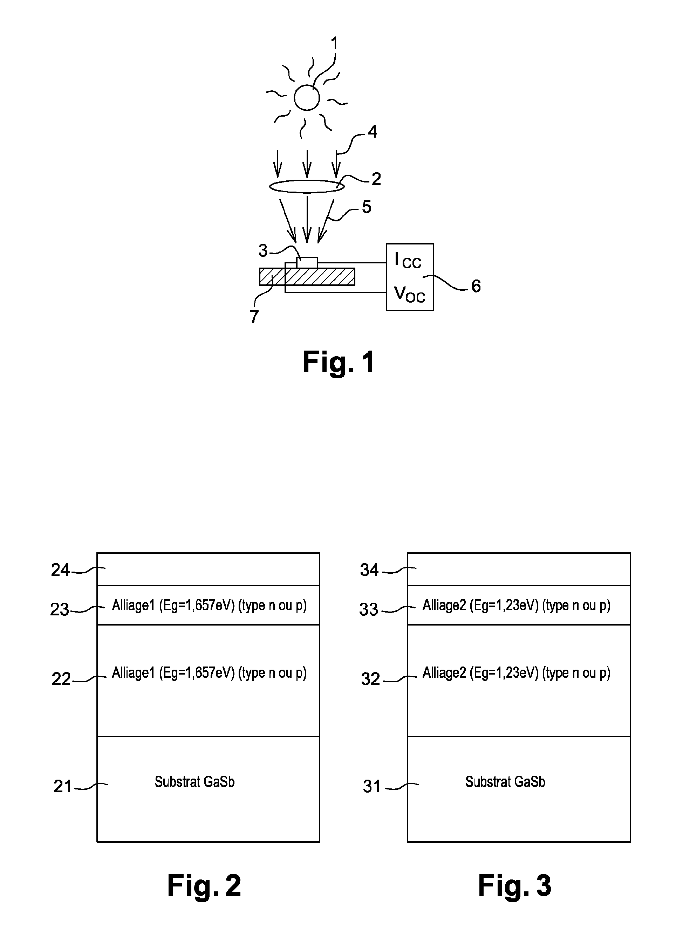

Le principe de concentration solaire est représenté sur la figure 1. Le soleil 1 éclaire un concentrateur 2. Le flux solaire 4 qui atteint le concentrateur 2 est transformé en un flux concentré 5 qui est guidé vers une cellule photovoltaïque 3 disposée sur un dispositif de refroidissement 7. Une unité de mesure 6 permet de récupérer un courant de court-circuit Icc et une tension en circuit ouvert Voc. Le courant électrique produit par la cellule 3 est proportionnel au flux lumineux qu'elle reçoit. En concentrant X fois le flux solaire sur la cellule à l'aide du concentrateur 2 (concentrateur parabolique ou lentille de Fresnel), on obtient un courant électrique X fois supérieur au courant obtenu sans concentration.

Dans des systèmes industriels photovoltaïques sous concentration, on peut utiliser une optique de concentration à double étage: en plus du concentrateur primaire (parabole ou lentille), on ajoute généralement une optique secondaire au foyer qui assure éventuellement une fonction de surconcentration, mais surtout d'homogénéisation du flux lumineux indispensable pour éviter une dégradation des performances de la cellule solaire. Pour des valeurs de concentration de quelques centaines de soleils (voire jusqu'à 1000 ou même au-delà pour une cellule de petites dimensions) un refroidissement passif (cellule reliée à un puits de chaleur refroidi par convection naturelle) est généralement suffisant pour limiter l'échauffement de la cellule. Aux plus fortes concentrations, un refroidissement actif (convection forcée) à l'aide d'un fluide caloporteur (eau) devient indispensable.

Sur la figure 2, on voit en exemple une cellule photovoltaïque selon l'invention. On distingue un substrat 21 de matériau GaSb sur lequel on a fait croître par épitaxie une première couche 22 présentant une énergie de gap égale à 1.657 eV. Cette couche 22 peut être dopée de type n ou p. On réalise ensuite sur la première couche 22, une seconde couche 23 mais d'une épaisseur plus petite. Les couches 22 et 23 sont réalisées à base d'un même matériau antimoniure, c'est-à-dire un même alliage dit alliage1, et présentent donc toutes deux une énergie de gap égale à 1.657 eV. La seconde couche 23 est dopée de type p ou n. Avantageusement, l'alliage1 est un matériau quaternaire à base de l'antimoine de sorte que l'on réalise un parfait accord de maille sur le substrat GaSb 21. On termine la cellule avec une couche de terminaison 24.

Sur la figure 3, on retrouve un substrat GaSb 31 sur lequel on réalise par croissance épitaxiale une première couche 32 présentant une énergie de gap égale à 1.23 eV. Cette couche 22 peut être dopée de type n ou p. On réalise ensuite sur cette première couche 32, une seconde couche 33 mais d'une épaisseur plus petite. Les couches 32 et 33 sont réalisées à base d'un même matériau antimoniure, c'est-à-dire un même alliage dit alliage2, et présentent donc toutes deux une énergie de gap égale à 1.23 eV. La seconde couche 33 est dopée de type p ou n. Avantageusement, l'alliage2 est un matériau quaternaire à base de l'antimoine de sorte que l'on réalise un parfait accord de maille sur le substrat GaSb 31. On termine la cellule avec une couche de terminaison 34.

Les niveaux d'énergie sont des données qui peuvent être approximatives. Par exemple l'énergie de gap de l'alliage2 est 1.23eV mais peut être également de 1.22eV.

L'énergie de gap du GaSb est de 0.726 eV. Les cellules des figures 2 et 3 permettent de capter le flux solaire sur un spectre étendu du fait que les énergies de gap sont complémentaires.

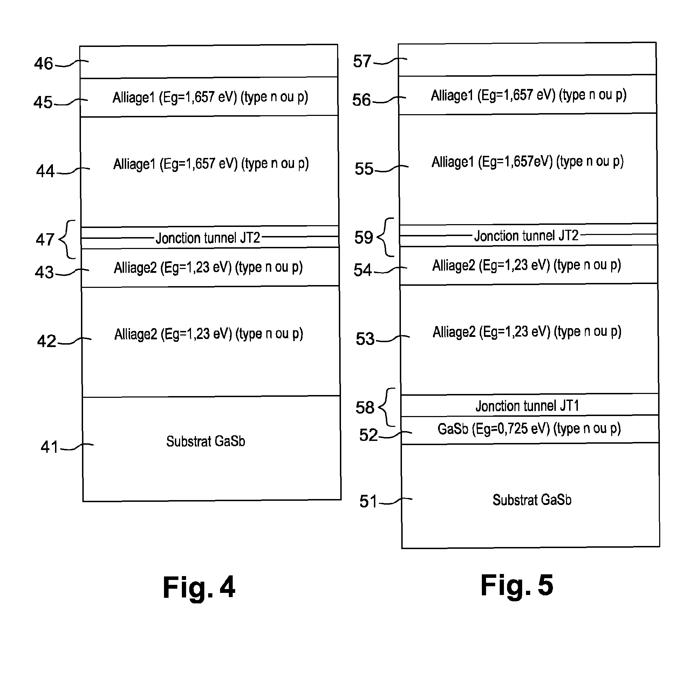

Afin d'étendre davantage ce spectre, on prévoit de réaliser plusieurs jonctions comme illustrées sur les figures 4 et 5.

Sur la figure 4, on retrouve un substrat GaSb 41 sur lequel on réalise par croissance épitaxiale une première couche 42 en alliage2 présentant une énergie de gap égale à 1,23 eV. Cette couche 42 peut être dopée de type n ou p. On réalise ensuite sur cette couche 42, une seconde couche 43 en alliage2 mais d'une épaisseur plus petite. La couche 43 est dopée de type p ou n. L'ensemble des deux couches 42 et 43 constitue une première jonction. On réalise ensuite une seconde jonction constituée par les couches 44 et 45 en alliage1. La couche 44 est dopée de type n ou p. La couche 45 réalisée directement sur la couche 44 est dopée de type p ou n. On termine la cellule avec une couche de terminaison 46. Avantageusement, entre les deux jonctions, on a réalisé par croissance épitaxiale, une jonction tunnel 47 ayant pour utilité l'extraction des porteurs issus de la première jonction vers le contact (couche de terminaison 46) de la cellule.

La figure 5 comporte idéalement trois jonctions réalisées sur le substrat GaSb 51. La première jonction comprend avantageusement une première couche constituée par le substrat 51 sur laquelle on réalise une seconde couche 52 de GaSb dopée de type n ou p. une jonction tunnel 58 permet d'extraire les porteurs issus de la jonction GaSb vers la deuxième jonction. On fait croître ensuite la seconde jonction composée de la couche 53 en alliage2 et la couche 54 en alliage2. De façon générale dans les cellules décrites, la seconde couche (la couche supérieure) est d'épaisseur inférieure à la première couche. Cependant d'autres dispositions sont possibles, telle une jonction où la couche supérieure serait d'épaisseur supérieure à la couche inférieure indépendamment de la disposition des autres jonctions.

Une seconde jonction tunnel 59 est réalisée sur la seconde jonction 53,54 de façon à faire croître une troisième jonction 55,56 composée de la couche 55 en alliage1 surmontée de la couche 56 en alliage1 également.

Les deux jonctions tunnels permettent un raccordement de bande entre les différentes jonctions de façon à obtenir une absorption efficace du spectre du flux solaire. On termine la cellule avec une couche de terminaison 57.

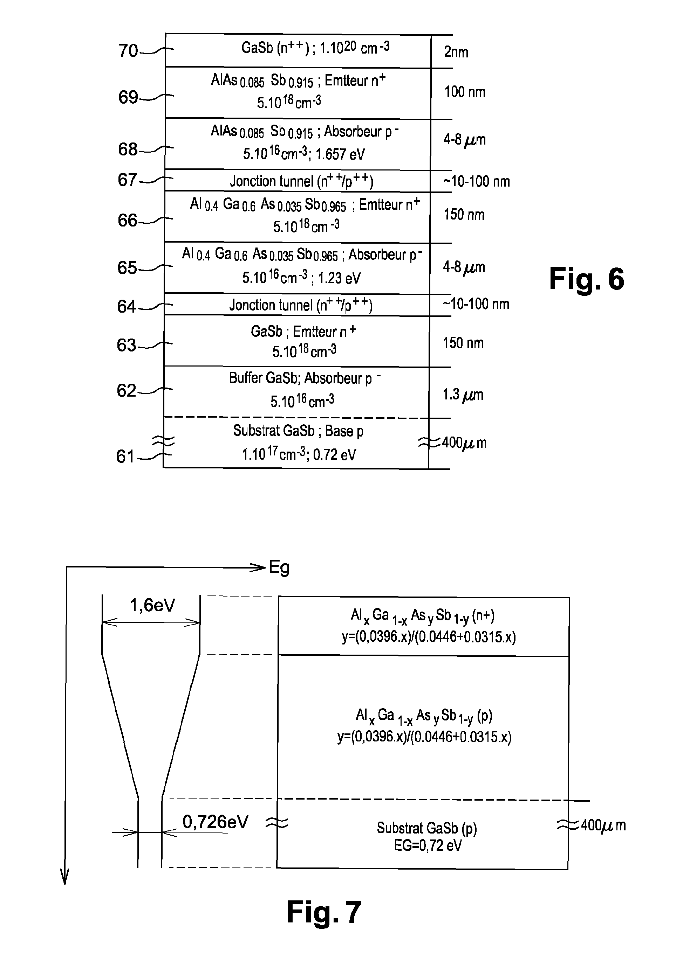

On va maintenant décrire en référence à la figure 6, un exemple préférentiel, non limitatif, d'une cellule photovoltaïque selon l'invention. Il s'agit d'une cellule à base de matériaux antimoniures présentant une très bonne complémentarité des gaps avec seulement trois jonctions toutes en accord de maille sur un substrat GaSb 61. Avantageusement, le substrat est dopé de type n avec une concentration de 1.10¹⁷cm⁻³ et une énergie de gap de 0.726eV. Son épaisseur est d'environ 400µm.

On réalise ensuite une couche tampon (« buffer ») 62 de matériau GaSb dopée de type p- avec une concentration de 5.10¹⁶cm⁻³. Son épaisseur est de 1.3µm. Cette couche 62 est associée à une couche 63 formant ensemble une première jonction. La couche 63 de matériau GaSb est dopée de type n+ avec une concentration de 5.10¹⁸cm⁻³. Son épaisseur est de 150nm. Cette couche présente une épaisseur largement inférieure, pratiquement un rapport de un à dix, par rapport à l'épaisseur de la couche 62. Dans le couple 62,63 formant jonction p-n, la couche 62 a un rôle absorbeur, alors que la couche 63 a plutôt un rôle émetteur.

On distingue une deuxième jonction 65,66 composée d'une couche 65 de matériau antimoniure, plus précisément un alliage quaternaire de composition Al_{0.4}Ga_{0.6}As_{0,035}Sb_{0.965}· Cette couche 65 est dopée de type p- avec une concentration de 5.10¹⁶cm⁻³. Son épaisseur est de 4 à 8µm. Cette couche 65 est associée à une couche 66 formant ensemble la deuxième jonction.

La couche 66 de matériau antimoniure, plus précisément un alliage quaternaire également de composition Al_{0.4}Ga_{0.6}AS_{0.035}Sb_{0.965}, est dopée de type n+ avec une concentration de 5.10¹⁸cm⁻³. Son épaisseur est de 150nm. Cette couche présente une épaisseur largement inférieure par rapport à l'épaisseur de la couche 65. Dans le couple 65,66 formant jonction p-n, la couche 65 a un rôle absorbeur, alors que la couche 66 a plutôt un rôle émetteur. Les deux couches présentent chacune une énergie de gap de 1.23eV.

Entre les deux jonctions 62,63 et 65,66, on réalise une jonction tunnel 64 qui est en fait une diode constituée par une première couche qui peut être réalisée en InAsGaSb dopée de type p++ avec une concentration de 1.10¹⁹cm⁻³, et une seconde couche dopée de type n++ avec une concentration de 1.10¹⁹cm⁻³. L'épaisseur de la jonction tunnel 64 est comprise entre 10 et 100 nm.

On peut utiliser différents types d'alliage pour les jonctions tunnels selon l'invention tels que par exemple :
- InAs
- GaSb
- GaₓIn₁₋ₓAs
- GaₓIn₁₋ₓSb
- GaAs₁₋ₓSbₓ
- AlₓGa₁₋ₓAs
- InAs₁₋ₓSbₓ
- GaₓIn₁₋ₓAs_{y}Sb_{1-y}
- AₓGa₁₋ₓAs_{y}Sb_{1-y}

Les jonctions tunnels selon l'invention peuvent être particulièrement caractérisées par un fort dopage (à partir de 1.10¹⁹cm⁻³), une épaisseur de l'ordre de 30nm (entre 10 et 100nm) et constituées par l'un des matériaux cités ci-dessus.

On peut ainsi déterminer le niveau d'énergie de gap de chaque jonction dans une plage continue de valeurs d'énergie, par exemple à partir du niveau d'énergie de gap du substrat. En l'occurrence cette plage peut aller du niveau d'énergie du gap du substrat de GaSb (725 meV) jusqu'à 1,64eV de façon continue, ce qui n'est pas le cas avec la filière GaInP/GaInAs, privilégiée dans l'état de l'art antérieur. Les niveaux d'énergie sont ainsi déterminés de façon à assurer une continuité d'absorption du flux solaire. En d'autres termes, l'alliage quaternaire peut présenter une énergie de gap comprise entre 0.725eV et 1.64eV en gap direct (2eV en gap indirect).

Une troisième jonction 68,69 est réalisée au-dessus de la deuxième jonction. Cette troisième jonction est composée d'une couche 68 de matériau antimoniure, plus précisément un alliage quaternaire de composition AlAs_{0.085y}Sb_{0.915}. Cette couche 68 est dopée de type p- avec une concentration de 5.10¹⁶cm⁻³. Son épaisseur est de 4µm à 8µm. Cette couche 68 est associée à la couche 69 formant ensemble la troisième jonction.

La couche 69 de matériau antimoniure, plus précisément un alliage quaternaire également de composition AlAs_{0.085}Sb_{0.915}, est dopée de type n avec une concentration de 5-10¹⁸cm⁻³. Son épaisseur est de 100nm. Cette couche présente une épaisseur largement inférieure par rapport à l'épaisseur de la couche 68. Dans le couple 68,69 formant jonction p-n, la couche 68 a un rôle absorbeur, alors que la couche 69 a plutôt un rôle émetteur.

Entre les deux jonctions 65,66 et 68,69, on réalise une jonction tunnel qui est en fait une diode constituée par une première couche dopée de type p++ avec une concentration de 1.10¹⁹cm⁻³, et une seconde couche dopée de type n++ avec une concentration de 1.10¹⁹cm⁻³. L'épaisseur de la jonction tunnel 67 est comprise entre 10 et 100nm.

Une dernière couche contact 70 est disposée sur la troisième jonction. Elle est constituée d'un matériau à base de GaSb dopé n⁺⁺ à 1.10²⁰ cm⁻³. Son épaisseur est d'environ 2nm.

La figure 7 illustre un exemple d'une cellule comprenant une seule jonction (d'autres jonctions de même type ou pas peuvent être ajoutées) présentant un niveau d'énergie de gap Eg variable. « L'entonnoir énergétique » représenté dans la zone dopée p est une simple illustration de la variation de l'énergie de gap Eg à l'intérieur de la cellule.

Ainsi, l'objet de la présente invention est une cellule solaire multi jonctions à très haut rendement optimisée pour une utilisation sous fortes concentrations solaires (>1000X). Elle est constituée à base de matériaux antimoniures (GaSb, Ga₁₋ₓAlₓAs_{y}Sb_{1-y}, ...) obtenues sous forme d'empilement monolithique préférentiellement par épitaxie par jets moléculaires (MBE pour *Molecular Beam Epitaxy*). L'utilisation de matériaux antimoniures qui sont des alliages quaternaires tous en accord de maille sur le substrat permet d'obtenir une très bonne complémentarité des gaps entre ces matériaux.

Les alliages utilisés permettent de faire varier le gap de façon continue entre 725 meV et plus de 2eV en restant en accord de maille sur le substrat de GaSb. Les filières GaInP/GaAs ou Ge ne permettent pas d'ajuster indépendamment le gap et le paramètre de maille des matériaux, ce qui ne permet pas d'obtenir tous les gaps nécessaires à une utilisation optimale du spectre solaire en particulier pour les énergies de gap inférieurs à 1,45eV.

Bien sûr, l'invention n'est pas limitée aux exemples qui viennent d'être décrits et de nombreux aménagements peuvent être apportés à ces exemples sans sortir du cadre de l'invention en particulier le nombre de jonctions et la composition des alliages utilisés. L'exemple de la figure 6 est basé sur un substrat de type p, mais on peut aussi concevoir une cellule basée sur un substrat de type n.

## Revendications

1. Cellule photovoltaïque utilisable sous forte concentration solaire, **caractérisée en ce qu'**elle consiste en une cellule comprenant au moins une jonction réalisée sur un substrat à base d'antimoniure de gallium GaSb, ladite au moins une jonction étant réalisée à base d'alliage antimoniure en accord de maille sur le substrat.

2. Cellule photovoltaïque selon la revendication 1, **caractérisée en ce qu'**en cas de plusieurs jonctions, deux jonctions voisines sont séparées par une jonction tunnel, et **en ce que** les jonctions sont constituées par des alliages de même nature et de compositions différentes tous en accord de maille sur le substrat GaSb.

3. Cellule photovoltaïque selon la revendication 1 ou 2, **caractérisée en ce que** ladite au moins une jonction présente un gradient du niveau d'énergie de gap.

4. Cellule photovoltaïque selon l'une quelconque des revendications précédentes, **caractérisée en ce que** l'alliage antimoniure est un matériau quaternaire.

5. Cellule photovoltaïque selon la revendication 4, **caractérisée en ce que** l'alliage quaternaire est un matériau Ga₁₋ₓAlₓAs_{y}Sb_{1-y}.

6. Cellule photovoltaïque selon la revendication 5, **caractérisée en ce que** le matériau Ga₁₋ₓAlₓAs_{y}Sb_{1-y} est tel que x est compris entre 0 et 1, et y=(0,0396.x)/(0.0446+0.0315.x).

7. Cellule photovoltaïque selon l'une quelconque des revendications précédentes, **caractérisée en ce qu'**elle comprend trois jonctions :
- une première jonction à base de deux matériaux composés chacun d'antimoniure de gallium et dopés respectivement de type n et de type p,
- une seconde jonction à base de deux matériaux dopés respectivement de type n et de type p, chacun étant un alliage quaternaire comprenant de l'antimoine,
- une troisième jonction à base de deux matériaux dopés respectivement de type n et de type p, chacun étant un alliage quaternaire comprenant de l'antimoine.

8. Cellule photovoltaïque selon l'une quelconque des revendications 4 à 7, **caractérisée en ce que** l'alliage quaternaire présente une énergie de gap comprise entre 0.725eV et 1.64eV en gap direct ou 2eV en gap indirect.

9. Cellule photovoltaïque selon la revendication 7 ou 8, **caractérisée en ce que** le niveau d'énergie de gap de la première jonction est égal à environ 0.726eV ; le niveau d'énergie de gap de la seconde jonction est égal à environ 1.2 eV ; et le niveau d'énergie de gap de la troisième jonction est égal à environ 1.6 eV.

10. Cellule photovoltaïque selon l'une quelconque des revendications 7 à 9, **caractérisée en ce que** l'alliage de la troisième jonction est le matériau AlAs_{0.085}Sb_{0.915}.

11. Cellule photovoltaïque selon l'une quelconque des revendications 7 à 10, **caractérisée en ce que** l'alliage de la seconde jonction est le matériau Al_{0.4}Ga_{0.6}AS_{0.035}Sb_{0.965}.

12. Cellule photovoltaïque selon l'une quelconque des revendications précédentes, **caractérisée en ce que** les jonctions tunnels sont réalisées à base de InAs/GaSb et sont dopées entre 1.10¹⁹ cm⁻³ et 10.10¹⁹ cm⁻³, de préférence à 1.10¹⁹ cm⁻³.

13. Cellule photovoltaïque selon l'une quelconque des revendications précédentes, **caractérisée en ce que** chaque jonction est dopée entre 1.10¹⁶ cm⁻³ et 10.10¹⁶ cm⁻³ pour les absorbeurs de type n, de préférence à 5.10¹⁶ cm⁻³, et entre 1.10¹⁸ cm⁻³ et 10.10¹⁸ cm⁻³ pour les émetteurs de type p, de préférence à 5.10¹⁸ cm⁻³.

14. Cellule photovoltaïque selon l'une quelconque des revendications 7 à 13, **caractérisée en ce que** :
- le substrat est de type p et présente une épaisseur de plusieurs centaines de µm;
- la première jonction présente une épaisseur comprise entre 1 µm et 2µm pour le matériau de type p et 150nm pour le matériau de type n ;
- la seconde jonction présente une épaisseur comprise entre 4µm et 8µm pour le matériau de type p et de 150nm pour le matériau de type n ;
- la troisième jonction présente une épaisseur comprise entre 4µm et 8µm pour le matériau de type p et de 100nm pour le matériau de type n.

15. Cellule photovoltaïque selon l'une quelconque des revendications 7 à 14, **caractérisée en ce que** les jonctions tunnels présentent chacun une épaisseur de 15nm par matériau de type p ou n.

16. Cellule photovoltaïque selon l'une quelconque des revendications précédentes, **caractérisée en ce que** chaque jonction tunnel est une diode dont le matériau de type n présente un dopage supérieur au dopage de l'alliage de type n directement voisine.

17. Cellule photovoltaïque selon l'une quelconque des revendications précédentes, **caractérisée en ce que** chaque jonction tunnel est une diode dont le matériau de type p présente un dopage supérieur au dopage de l'alliage de type p directement voisine.
